# EUROPEAN PATENT APPLICATION

(11) **EP 4 685 842 A1**
(43) Date of publication of application: **28.01.2026**
(21) Application number: 25180250.0
(22) Date of filing: 02.06.2025
(51) Int. Cl.: H01L 21/3065, H01L 21/311, H01L 21/78

(54) **A METHOD OF PLASMA DICING A SEMICONDUCTOR WAFER**

(30) Priority: 26.07.2024 GB 202410953
(71) Applicant: SPTS Technologies Limited, Newport Gwent NP18 2TA (GB)
(72) Inventor: Dawson, Simon, Cardiff, CF14 9BD (GB); Fan, Weikang, Wotton-Under-Edge, GL12 8FF (GB); Chai, Guoqing, Wuhan, 430073 (CN)
(74) Representative: Wynne-Jones IP Limited

(57) **Abstract**

There is provided a method of plasma dicing a semiconductor wafer. The method includes a step of providing a semiconductor wafer comprising a main silicon layer and a top silicon oxide layer covered with an organic soft mask. The mask defines a plurality of scribe line regions to be etched. The method includes a step of plasma etching to remove the top silicon oxide layer in the scribe line regions to expose the main silicon layer, wherein the plasma etching is performed using an etch chemistry comprising gaseous SF₆ gas mixed with gaseous Ar. The method includes a step of plasma etching to remove the main silicon layer in the scribe line regions to provide a plurality of individual semiconductor die.

## Description

### Field

The invention relates to methods of plasma dicing semiconductor wafers, in particular methods of plasma dicing semiconductor wafers by inductively coupled plasma reactive ion (ICP-RIE) etching through an organic mask. The invention also relates to plasma etch apparatuses configured to perform methods of plasma dicing semiconductor wafers.

### Background

During the manufacture of semiconductor or micro-electro-mechanical system (MEMS) devices on a semiconductor wafer, a wafer dicing, or scribing step is required to segment the wafer into individual die (i.e. semiconductor chips). Prior to the wafer dicing or scribing step, the wafers are attached to a support structure in order to support the discrete die post singulation. Once the singulation operation has been completed, individual die can be removed from the support structure to be tested and incorporated in packaged devices.

The division of semiconductor wafers into individual die can be achieved by mechanical scribing, sawing, laser scribing, plasma etching or a combination of such techniques.

However, it is found that both scribing and sawing of wafers can cause gouges or other defects to form along the edges of the separated die. Such defects can be problematic, for example in applications which require hybrid and fusion bonding of die where surfaces need to be exceedingly smooth, typically to less than 1 nm. The presence of small particles can lead to poor die to die bonding. Cleanliness is of high importance. In addition, cracks can form and propagate from the edges of the die into the substrate and render the integrated circuitry disposed thereon inoperative. The problem of chipping and crack propagation requires additional spacing between the die on the wafer to prevent damage to the integrated circuits.

The increased spacing requirement effectively reduces the economic value to be obtained from the wafer.

A more recent approach to the separation of die on semiconductor wafers utilises plasma etching of the wafer in a defined pattern (for example in perpendicular "streets", or "lanes"). Plasma dicing has been found to provide reduced damage to the edges of the die. As a consequence a narrower cut can be achieved, which therefore provides for a more closely packed arrangement of die upon the wafer. Furthermore, plasma dicing enables different shapes and layouts of die to be fabricated that cannot be achieved with mechanical scribing.

The dicing of a wafer using a plasma requires the wafer to be initially coated with a mask in order to define the dicing pattern (i.e. a plurality of etch regions). The mask may be a hard mask formed from a material such as silicon nitride or may be an organic, soft, mask. Advantageously, using a soft mask enables the resist mask to be applied directly onto the silicon oxide layer, thus saving cost. In applications the mask is typically a photoresist mask applied through a photolithographic process to form a dicing pattern. After etching according to the dicing pattern to create deep channels in the wafer, the mask is removed in a strip process.

A drawback of plasma dicing with an organic mask is unwanted deposition of polymer material on the sides of the mask and/or die adjacent the etch regions. During the etching process, inorganic matter such as fluorine compounds and/or elements such as silicon can be incorporated in the polymer deposits. When the mask is removed, a residue can be left over in the vicinity of the open regions of the mask and filaments are exposed. The filaments are not easily removable, and provide an obstruction. Furthermore, fluorine present in the filaments can pose a corrosion concern for exposed metal areas of the die.

There is a requirement for an improved method of plasma dicing a semiconductor wafer which mitigates the above mentioned problems.

### Summary

In a first aspect of the invention there is provided a method of plasma dicing a semiconductor wafer. The method includes the step of providing a semiconductor wafer comprising a main silicon layer and a top silicon oxide layer. The top silicon oxide layer is covered with an organic soft mask, the mask defining a plurality of scribe line regions to be etched. The method includes the step of plasma etching to remove the top silicon oxide layer in the scribe line regions to expose the main silicon layer, wherein the plasma etching is performed using an etch chemistry comprising gaseous SF₆ gas mixed with gaseous Ar. The method includes the step of plasma etching to remove the main silicon layer in the scribe line regions to provide a plurality of individual semiconductor die, for example using a cyclic Bosch process.

The inventors have found that by using a plasma formed from Ar and SF₆ gases for the silicon oxide etch, the formation of polymer deposits on the sidewalls of the mask and/or silicon oxide layer during the etch can be reduced or prevented entirely. Moreover the incorporation of inorganic matter for example silicon in any polymer deposits which do form is greatly reduced or prevented. In the method of the present invention which utilises a different etch chemistry to methods of the prior art, although some polymer may still be deposited it is in comparatively small amounts and without the incorporation of inorganic matter. Therefore any polymer deposited can be removed by plasma ashing. It is believed that the fluorine in the etch plasma helps to prevent silicon or other inorganic matter from depositing in the polymer.

The etch chemistry for the silicon oxide etch may be an oxygen-free etch chemistry. The etch chemistry may alternatively or additionally be a carbon monoxide-free etch chemistry.

The plasma etching to remove the main silicon layer may be performed using an etch chemistry comprising gaseous SF₆ gas mixed with gaseous Ar. The etch chemistry may be the same etch chemistry used for the silicon oxide etch.

The organic soft mask may comprise a polymer based mask. The organic soft mask may comprise a photoresist mask.

The semiconductor wafer may be supported on a substrate support. The substrate support may be a glass or silicon support structure. The substrate support may be a tape and frame assembly.

The method may further comprise the step of plasma ashing to remove the mask. The plasma ashing may be performed using an oxygen or argon based ashing chemistry.

The plasma etching to remove the main silicon layer may comprise a cyclic Bosch etch process.

The semiconductor wafer may further comprise one or more metal layers. The metal layers may for example be embedded in the silicon oxide layer.

The plasma etching to remove the top silicon oxide layer may be performed at a pressure of 20-50 milli Torr.

The plasma etching to remove the top silicon oxide layer may be performed using an Ar flow rate of 100-350 sccm.

The plasma etching to remove the top silicon oxide layer may be performed using an Ar flow rate of 140-170 sccm.

The plasma etching to remove the top silicon oxide layer may be performed using an SF₆ flow rate of 30-100 sccm.

The plasma etching to remove the top silicon oxide layer may be performed using an SF₆ flow rate of 40-50 sccm.

A method according to any preceding claim, wherein the etch chemistry for the silicon oxide etch further comprises gaseous C₄F₈. The C₄F₈ flow rate may be less than the SF₆ flow rate for example <50% of the SF₆ flow rate.

The plasma etching to remove the top silicon oxide layer may be undertaken at an RF power in the range 1000-3000 W. The plasma etching to remove the top silicon oxide layer may be undertaken at an RF bias power in the range 1500-5000 W.

In a second aspect of the invention there is provided a plasma etch apparatus configured to perform a method according to the first aspect of the invention. The plasma etch apparatus comprises a chamber. The plasma etch apparatus comprises a plasma generator associated with the chamber and configured to generate a plasma from at least Ar and SF₆ gases received in the chamber. The plasma etch apparatus comprises a substrate support configured to support a semiconductor wafer comprising a main silicon layer and a top SiO₂ layer covered with a mask, the mask defining a plurality of scribe line regions to be etched, the substrate support being arranged with respect to the chamber such that in use, the plasma contacts the semiconductor wafer. The plasma etch apparatus comprises a controller configured to cause the apparatus to perform a plasma etch to remove the top silicon oxide layer in the scribe line regions, and subsequently to perform a plasma etch to remove the main silicon layer in the scribe line regions.

### Drawings

A prior art method and an embodiment of the present invention will now be described by way of example only with reference to the accompanying schematic drawings:
Figure 1 illustrates a first step in the prior art method of plasma dicing a semiconductor wafer;
Figure 2 illustrates a second step in the prior art method of plasma dicing a semiconductor wafer;
Figure 3 illustrates a third step in the prior art method of plasma dicing a semiconductor wafer;
Figure 4 illustrates a fourth step in the prior art method of plasma dicing a semiconductor wafer;
Figure 5 is a flow diagram of a method of plasma dicing a semiconductor wafer according to the example embodiment of the invention;
Figure 6 illustrates a first step in the method of plasma dicing a semiconductor wafer according to the example embodiment of the invention;
Figure 7 illustrates a second step in the method of plasma dicing a semiconductor wafer according to the example embodiment of the invention;
Figure 8 illustrates a third step in the method of plasma dicing a semiconductor wafer according to the example embodiment of the invention;
Figure 9 illustrates a fourth step in the method of plasma dicing a semiconductor wafer according to the example embodiment of the invention; and
Figure 10 is a schematic side view of an etch apparatus configured to undertake the method of plasma dicing a semiconductor wafer according to the example embodiment of the invention.

### Detailed description

### Prior art

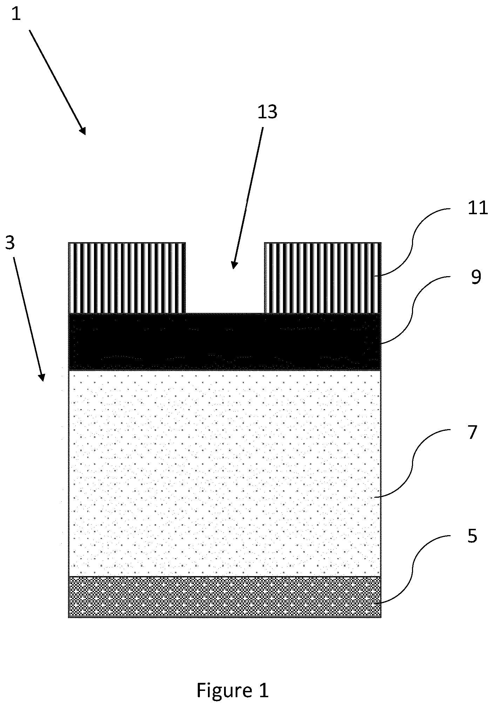

In a first step of a prior art method of plasma dicing a semiconductor wafer (Figure 1) there is provided a semiconductor wafer assembly 1 within the chamber of an etch apparatus. The semiconductor wafer assembly 1 comprises a semiconductor wafer 3 supported on a tape 5. The semiconductor wafer 3 comprises a thick silicon substrate layer 7 above the tape 5, and a silicon oxide (SiO₂) layer 9 above the silicon substrate layer 7. The wafer 3 is covered with a polymeric organic mask 11 patterned to define scribe line regions 13 through which the wafer 3 will be plasma etched to separate the wafer into individual dies.

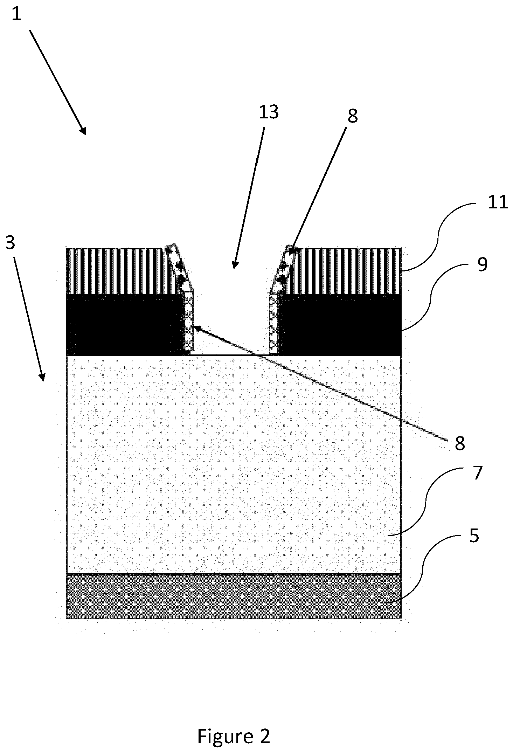

In a second step of the prior art method (Figure 2), the silicon oxide layer 9 is plasma etched within the chamber of the etch apparatus using a plasma formed from CₓF_{y} and/or CₓH_{y}F_{z} with O₂ or CO and Ar gases. The etch is directional (anisotropic) so that straight sided walls are formed in the silicon oxide layer 9. Meanwhile, the edges of the mask 11 are etched slightly to provide angled edges. The mask is etched by incoming ions and radicals. However, as not all of the ions are approaching normal to the wafer surface, there is some lateral removal of the mask (most prominently at the top of the mask) resulting in sloped edges. During the etch, inorganic deposits 8 containing fluorine are built up at the edges of the mask 11 and silicon oxide layer 9 in the scribe line regions 13.

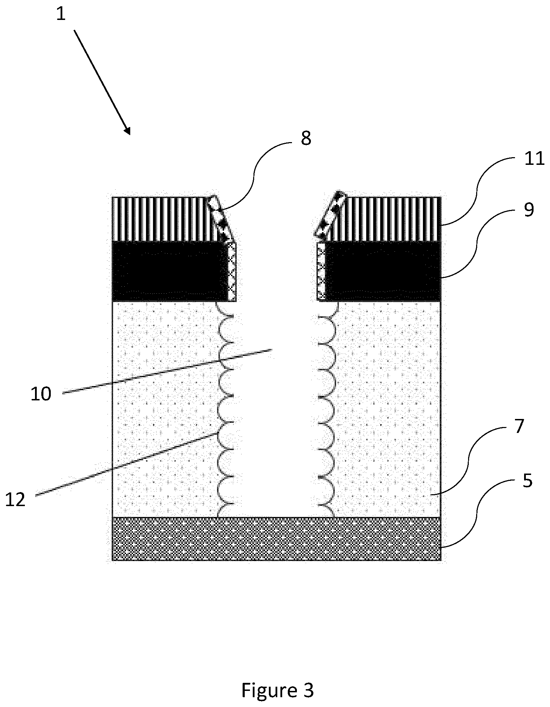

In a third step of the prior art method (Figure 3), the silicon layer 7 is etched within the chamber of the etch apparatus using a plasma formed from SF₆ or SF₆ + Ar gases (with a C₄F₈ deposition step). The etch is undertaken as a rapid anisotropic etch in a cyclic Bosch process (as is known in the art and not described further herein), to form deep channels in the silicon layer 7 having scalloped edges 12.

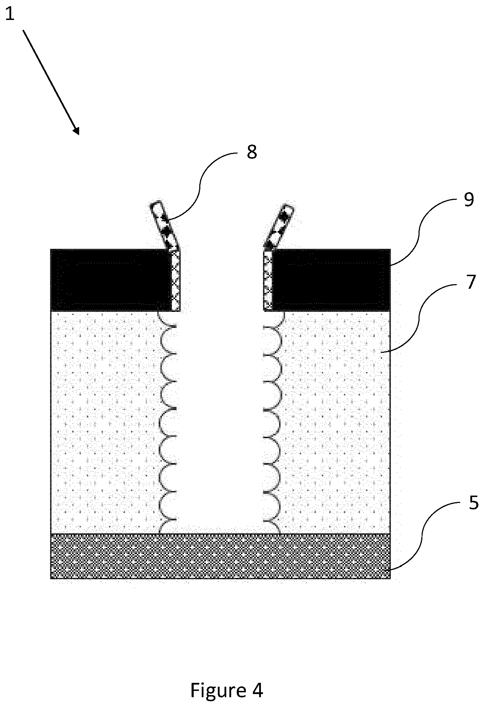

In a fourth step of the prior art method (Figure 4), the polymeric mask 11 is removed by plasma ashing in an oxygen-based strip step. The process of plasma ashing to strip the mask is known in the art and not described further herein. The inorganic deposits 8 remain after the plasma ashing step as unwanted filaments of polymer residue protruding from the sides of the silicon oxide layer at the edges of the separated dies.

### Invention

The present invention provides a method of plasma dicing a semiconductor wafer which avoids the formation of filaments at the edges of the die.

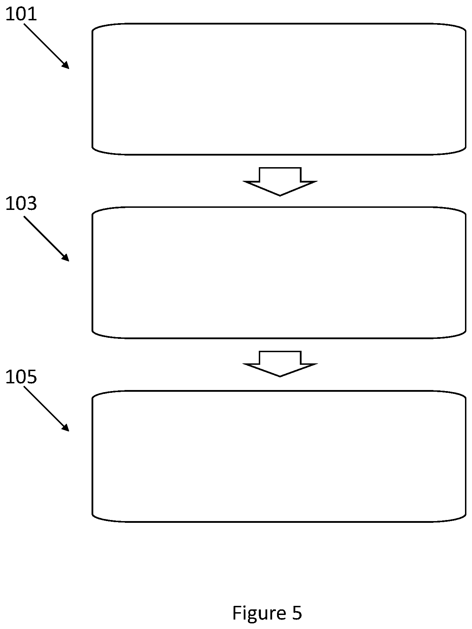

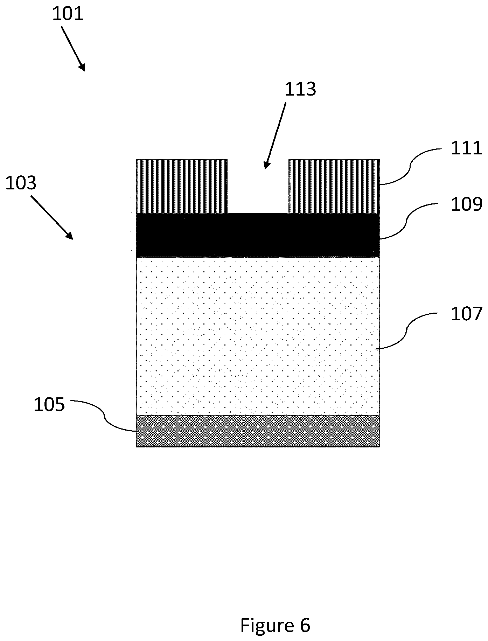

In embodiments of the invention, a method of plasma dicing a semiconductor wafer (Figure 5) comprises at least three steps. The method comprises a first step 101 of providing a semiconductor wafer (for example the wafer shown in Figure 6 and described in more detail below) comprising a main silicon layer and a top silicon oxide (SiO₂) layer covered with a mask, the mask defining a plurality of scribe line regions to be etched. The method comprises a second step 103 of plasma etching to remove the top silicon oxide layer in the scribe line regions to expose the main silicon layer, wherein the plasma etching is performed using an etch chemistry comprising gaseous SF₆ gas mixed with gaseous Ar. The method comprises a third step 105 of plasma etching to remove the main silicon layer in the scribe line regions to provide a plurality of isolated semiconductor die. By utilising an etch chemistry comprising gaseous SF₆ gas mixed with gaseous Ar for the silicon oxide etch, the formation of filaments at the edges of the separated dies is avoided during the etch.

In more detail, in the example embodiment of the invention, in the first step (Figure 6) there is provided a semiconductor wafer assembly 101 within the chamber of an etch apparatus. The semiconductor wafer assembly 101 comprises a semiconductor wafer 103 supported on a support structure in the example embodiment being a tape 105. The semiconductor wafer 103 comprises a thick silicon substrate layer 107 above the support structure 105, and a silicon oxide (SiO₂) layer 109 above the silicon substrate layer 107. The wafer 103 is covered with a polymeric organic mask 111 patterned to define scribe line regions 113 through which the wafer 103 will be plasma etched. In another embodiment there may be one or more metal layers embedded in the silicon oxide layer 109 for example forming a laminate structure. In the example embodiment of the invention, the semiconductor wafer 103 is a 300 mm wafer. The silicon layer 107 is approximately 40-60 µm thick, and the silicon oxide layer 109 is approximately 5-10 µm thick. In the example embodiment, the mask 111 is a photoresist mask approximately 3-15 µm thick, with ~15% open area, defining scribe line regions 113 comprising lanes of width 7-43 µm. During curing of the photoresist the mask deforms slightly, in the example embodiment causing the corners of the mask in the scribe line regions to be angled at an angle of >55%.

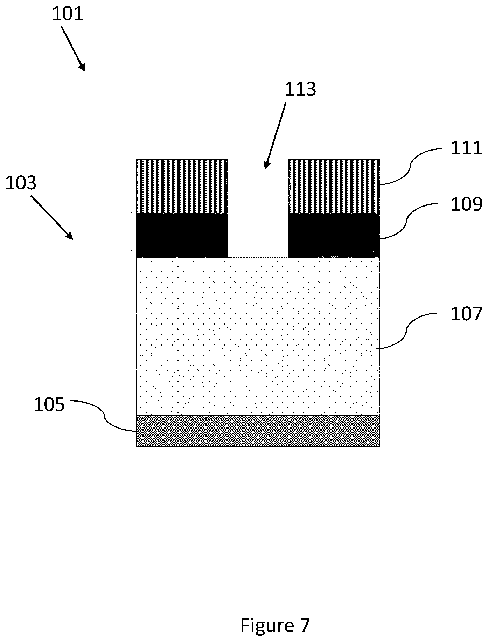

In the example embodiment of the invention, in the second step (Figure 7), the silicon oxide layer 109 is plasma etched within the chamber of the etch apparatus using a plasma formed from SF₆ and Ar gases. The etch is highly directional (anisotropic) and straight sided walls are formed in the silicon oxide layer 109. In contrast to methods of the prior art, the use of an etch chemistry comprising SF₆ and Ar gases has been found to eliminate the incorporation of inorganic matter such as silicon or fluorine compounds in a polymer layer on the mask and walls of the silicon oxide layer in the vicinity of the etch regions thereby preventing the formation of residual filaments after ashing of the mask. Unwanted contamination of the wafer assembly by fluorine compounds is therefore significantly reduced and/or avoided and corrosion of the die pads and die surfaces is prevented. During the etch the mask may also be somewhat etched, becoming thinner.

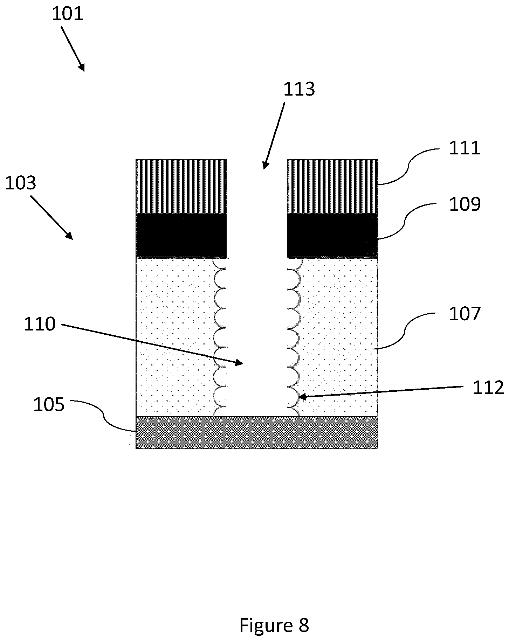

In the example embodiment of the invention, in the third step (Figure 8), the silicon layer 107 is etched within the chamber of the etch apparatus using a plasma similarly formed from SF₆ and Ar gases. The etch is undertaken as a rapid anisotropic etch in a cyclic Bosch process (as is known in the art and not described further herein), to form deep channels 110 in the silicon having scalloped edges 112. Thus the wafer 103 is separated into individual dies.

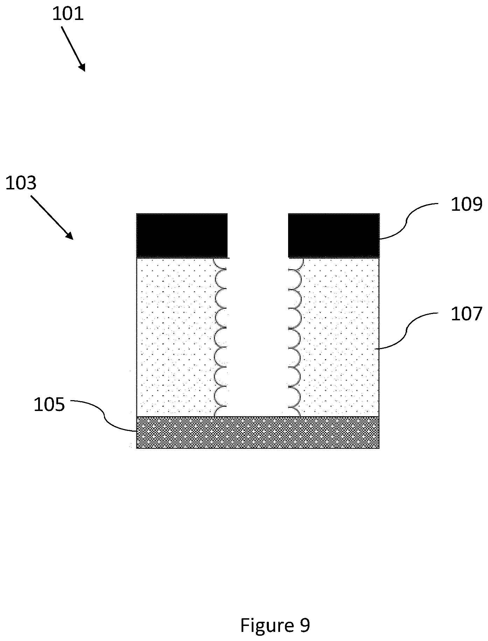

In the example embodiment of the invention, in a fourth step (Figure 9), the polymeric mask 111 is removed by plasma ashing in an oxygen-based strip step. The plasma ashing to strip the mask is a process known in the art and not described further herein. Due to the use of the etch chemistry comprising Ar and SF6 for the silicon oxide etch step, there is virtually no polymer residue on the separated dies and consequently no filament formation at the edges of the silicon oxide layer adjacent to the scribe lines. The mask is removed and no residual filaments are left.

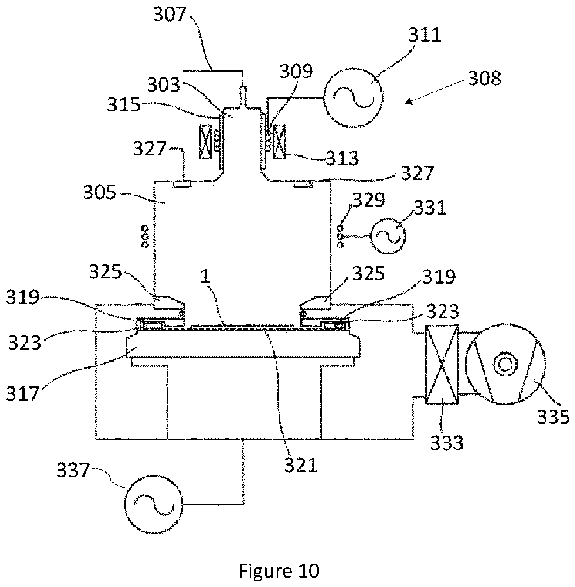

According to the example embodiment of the invention, all of the steps of the method are undertaken using a plasma etch apparatus (Figure 10) for example in the first example embodiment of the invention, the Rapier XE ^{™}. In an alternative embodiment, some of the steps, for example the plasma ashing step may be undertaken on a different apparatus.

The plasma etch apparatus 301 comprises a first chamber 303 disposed above a second larger chamber 305. A first plasma generator 308 in the form of a cylindrical ICP source 309 connected to a first RF (~13.56 MHz) power supply 311, is arranged at the periphery of the first chamber, and configured to excite electrons in a gas within the first chamber by generating varying magnetic fields to induce electric fields. A first gas inlet 307 feeds a first process gas (in the example embodiment of the invention being Ar) into the first chamber 303, wherein a primary plasma is generated through electromagnetic induction followed by ion generation.

A DC coil 313 is used to control the shape of the plasma leaving the first chamber 303. A faraday shield 315 reduces capacitive coupling from the ICP source, i.e. making it predominantly inductive.

The plasma flows into the second chamber 305 where it contacts the semiconductor wafer assembly 101 supported on an electrostatic chuck 317. The semiconductor wafer assembly 101 (including the tape 105) is held in a frame 323. In the example embodiment, the edge of the semiconductor wafer assembly 101 is protected by a wafer edge protection (WEP) device 319. A baffle 325 above the electrostatic chuck 317 is arranged to control gas flow in the vicinity of the semiconductor wafer assembly.

A second gas inlet 327 is disposed in an annular arrangement at the top of the second chamber 305, and arranged to feed a second process gas (in the example embodiment of the invention being SF₆) into the second chamber. A second plasma generator 329 connected to a second RF (~13.56 MHz) power supply 331 provides a second cylindrical ICP source. A coaxial source helps to increase the etch rate towards the edge of the semiconductor wafer assembly. The second plasma generator 329 is arranged at the periphery of the second chamber, and configured to generate a secondary plasma from the second process gas at the periphery of the second chamber 305. The two plasmas mix in the chamber and provide a more evenly distributed plasma over the semiconductor wafer assembly 101.

The flow of the gas through the chambers is assisted by a pump 335 and valve 333. A separate power supply 337 (also at ~13.56 MHz although frequencies of 2-20 MHz could be used) provides an RF bias power on the electrode i.e. support associated with the semiconductor wafer assembly 101.

In the example embodiment of the invention, the electrostatic chuck 317 is used to control the wafer temperature in the range -15°C to 10°C. The conditions for the silicon oxide etch were low pressure (in the range 20-50 milli Torr, for example ~30 milli Torr), high RF powers (in the range 1000-3000 W, for example ~2000 W and ~2450 W for the first and second RF power supplies respectively), high RF bias power (in the range 1500-5000 W, for example ~2500 W), and moderate gas flow rates (in the range 100-350 sccm for Ar and 30-100 sccm for SF₆, for example ~152 sccm and ~48 sccm respectively).

In an alternative embodiment of the invention, a third process gas may be supplied, for example C₄F₈ fed into the second chamber and mixed with the second process gas. In such an embodiment the gaseous C₄F₈ may be fed at a flow rate in the range 5-30 sccm, for example ~10 sccm. In such an embodiment the Ar flow rate may be adjusted to ~162 sccm, all other etch parameters remaining the same. Addition of C₄F₈ as a third process gas has been found to provide an improved mask/ silicon oxide selectivity to ~1.2:1 compared to ~1:1 which still maintaining a residue-free die outer surface. Accordingly, the SiO₂ etches 1.2x faster than the mask, as opposed to at the same etch rate, which is advantageous as it enables a thinner mask to be used.

## Claims

1. A method of plasma dicing a semiconductor wafer including the steps of:
providing a semiconductor wafer comprising a main silicon layer and a top silicon oxide layer covered with an organic soft mask, the mask defining a plurality of scribe line regions to be etched;
plasma etching to remove the top silicon oxide layer in the scribe line regions to expose the main silicon layer, wherein the plasma etching is performed using an etch chemistry comprising gaseous SF₆ gas mixed with gaseous Ar; and
plasma etching to remove the main silicon layer in the scribe line regions to provide a plurality of individual semiconductor die.

2. A method according to claim 1, wherein the etch chemistry is an oxygen-free etch chemistry.

3. A method according to any preceding claim, wherein the etch chemistry is a carbon monoxide-free etch chemistry.

4. A method according to any preceding claim, wherein the plasma etching to remove the main silicon layer is performed using an etch chemistry comprising gaseous SF₆ gas mixed with gaseous Ar.

5. A method according to any preceding claim, wherein the organic soft mask comprises a polymer based mask, optionally wherein the organic soft mask comprises a photoresist mask.

6. A method according to any preceding claim, wherein the semiconductor wafer is supported on a substrate support, optionally wherein the substrate support is a glass or silicon support structure or a tape and frame assembly.

7. A method according to any preceding claim, further comprising the step of plasma ashing to remove the mask, optionally wherein the plasma ashing is performed using an oxygen or argon based ashing chemistry.

8. A method according to any preceding claim, wherein the plasma etching to remove the main silicon layer comprises a cyclic Bosch etch process.

9. A method according to any preceding claim, wherein the semiconductor wafer further comprises one or more metal layers.

10. A method according to any preceding claim, wherein the plasma etching to remove the top silicon oxide layer is performed at a pressure of 20-50 milli Torr.

11. A method according to any preceding claim, wherein the plasma etching to remove the top silicon oxide layer is performed using an Ar flow rate of 100-350 sccm, optionally using an Ar flow rate of 140-170 sccm.

12. A method according to any preceding claim, wherein the plasma etching to remove the top silicon oxide layer is performed using an SF₆ flow rate of 30-100 sccm, optionally using an SF₆ flow rate of 40-50 sccm.

13. A method according to any preceding claim, wherein the etch chemistry for the silicon oxide etch further comprises gaseous C₄F₈.

14. A method according to any preceding claim, wherein the plasma etching to remove the top silicon oxide layer is at an RF power in the range 1000-3000 W and an RF bias power in the range 1500-5000 W.

15. A plasma etch apparatus configured to perform a method according to any of claims 1-14, the plasma etch apparatus comprising:
a chamber;
a plasma generator associated with the chamber and configured to generate a plasma from at least Ar and SF₆ gases received in the chamber;
a substrate support configured to support a semiconductor wafer comprising a main silicon layer and a top SiO₂ layer covered with a mask, the mask defining a plurality of scribe line regions to be etched, the substrate support being arranged with respect to the chamber such that in use, the plasma contacts the semiconductor wafer; and
a controller configured to cause the apparatus to perform a plasma etch to remove the top silicon oxide layer in the scribe line regions, and
subsequently to perform a plasma etch to remove the main silicon layer in the scribe line regions.
